## Europäisches Patentamt

## European Patent Office

## Office européen des brevets

(19)

(11) Veröffentlichungsnummer: **0 073 059**
**B1**

(12) # EUROPÄISCHE PATENTSCHRIFT

(45) Veröffentlichungstag der Patentschrift:
**07.01.87**

(51) Int. Cl.⁴: **G 01 R 15/07**

(21) Anmeldenummer: **82107766.6**

(22) Anmeldetag: **24.08.82**

(54) **Überwachungsschaltung für einen Thyristor.**

(30) Priorität: **28.08.81 JP 134251/81**

(43) Veröffentlichungstag der Anmeldung:
**02.03.83 Patentblatt 83/9**

(45) Bekanntmachung des Hinweises auf die Patenterteilung:
**07.01.87 Patentblatt 87/2**

(84) Benannte Vertragsstaaten:
**AT DE FR GB SE**

(56) Entgegenhaltungen:
**DE - A - 2 234 973**
**DE - A - 2 257 846**

(73) Patentinhaber: **FUJI ELECTRIC CO. LTD., 1-1,**
**Tanabeshinden, Kawasaki-ku, Kawasaki 210 (JP)**

(72) Erfinder: **Shigeo, Konishi, Dipl.-Ing., 2-46-5, Toyoda**
**Hino-shi, Tokyo (JP)**
Erfinder: **Osamu, Motoyoshi, Dipl.-Ing., 1270-4,**
**Narahara-mach, Hachioozi-shi Tokyo (JP)**

(74) Vertreter: **Mehl, Ernst, Dipl.-Ing. et al, Postfach 22 01 76,**
**D-8000 München 22 (DE)**

## Beschreibung

Die Erfindung betrifft eine Überwachungsschaltung für einen Thyristor zur Überwachung auf Kurzschluss und Überspannung mit einem Spannungsfühler für die am Thyristor anstehende Spannung, mit einer Schutzschaltung zur Zündung des Thyristors bei anstehender Überspannung sowie mit einer Leuchtdiodenanordnung, die bei Ansprechen des Spannungsfühlers bei abgeschaltetem Thyristor und bei Ansprechen der Schutzschaltung je eine Meldung in Form eines Lichtsignals aussendet, wobei die Leuchtdiodenanordnung über eine Lichtleiteranordnung mit einer Überwachungsschaltung für Kurzschluss und Überspannung verbunden ist.

Eine derartige Überwachungsschaltung ist bei auf dem Markt befindlichen Thyristor-Umrichtern vorgesehen.

In Überwachungsschaltungen für Umrichter mit vielen in Serie geschalteten Thyristoren werden häufig Lichtleiter eingesetzt, die eine hervorragende Isolation und Störsicherheit bieten, da bei solchen Umrichtern sehr hohe Spannungen und schnelle Potentialwechsel auftreten. Zur Überwachung einer Vielzahl von Thyristoren sind jedoch zahlreiche kostspielige optische Elemente wie z.B. Lichtleiter erforderlich. Dadurch wird eine derartige Überwachung kostspielig und kompliziert.

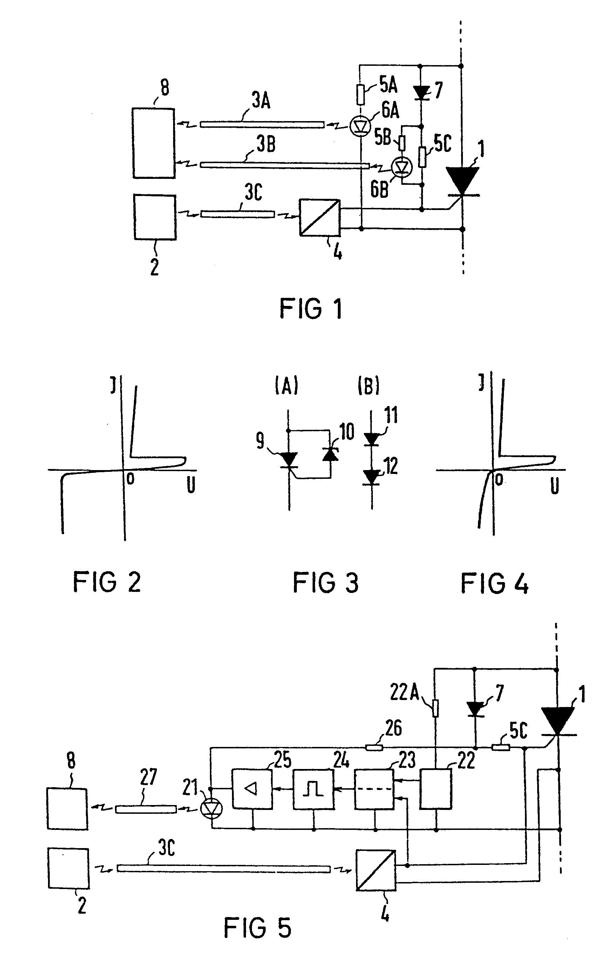

Eine bekannte Überwachungsschaltung für Thyristoren mit Lichtleitern für Störmeldungen sowie mit einer Schutzschaltung gegen Überspannung wird im folgenden anhand der Figuren 1 bis 4 dargestellt. Figur 1 zeigt eine Thyristor-Überwachungsschaltung eines Hochspannungs-Thyristorumrichters mit einer Vielzahl in Serie verbundener Einheiten. Jede Einheit enthält einen Thyristor 1, an dem eine Wechselspannung ansteht, eine Ansteuereinheit 2, Lichtleiter 3A, 3B und 3C und einen fotoelektrischen Wandler 4 zur Umwandlung des von der Ansteuereinheit 2 über den Lichtleiter 3C übertragenen Lichtsignals in ein elektrisches Signal. Der Ausgang des fotoelektrischen Wandlers 4 ist mit dem Gate des Thyristors 1 verbunden. Die Elemente 5A, 5B und 5C sind Widerstände, während 6A und 6B Leuchtdioden sind. Der Widerstand 5A und die Leuchtdiode 6A sind in Serie miteinander verbunden und beide Enden dieser Serienschaltung sind mit der Anode bzw. der Kathode des Thyristors 1 verbunden. Der Anoden-Kathoden-Strecke des Thyristors 1 ist ausserdem die Reihenschaltung einer Breakover-Diode 7 und eines Widerstands 5C parallel geschaltet. Die aus dem Widerstand 5B und der Leuchtdiode 6B bestehende Reihenschaltung ist mit den beiden Anschlüssen des Widerstands 5C verbunden. Damit kann ein Teil des zum Widerstand 5C fliessenden Stroms über den Widerstand 5B zur Leuchtdiode 6B fliessen. Die Einheit enthält ausserdem eine Meldeschaltung 8, der die von den Leuchtdioden 6A und 6B ausgesandten Lichtsignale jeweils über die Lichtleiter 3A und 3B zugeführt sind.

Ein durch die Lichtleiter 3C übertragenes Lichtsignal der Ansteuereinheit 2 wird also mit dem fotoelektrischen Wandler 4 in ein elektrisches Signal umgewandelt. Das in einen elektrischen Impuls umgewandelte Lichtsignal wird dem Gate des Thyristors 1 zugeführt. Damit wird also der Thyristor 1 durch die Ansteuereinheit 2 angesteuert. Sobald dem Gate des Thyristors 1 ein Zündimpuls zugeführt wird, zündet der Thyristor 1 und schaltet dann wieder ab. Wenn an der Anoden-Kathoden-Strecke des Thyristors 1 eine Spannung ansteht, so steht auch an der Leuchtdiode 6A eine Spannung an. Diese erzeugt damit ein Lichtsignal, das über den Lichtleiter 3A der Meldeeinheit 8 zugeführt wird. Wenn der Thyristor 1 fehlerfrei ist, verursacht also die während einer Sperrphase anstehende Spannung an der Anoden-Kathoden-Strecke des Thyristors 1 einen Stromfluss durch die Leuchtdiode 6A. Das von der Leuchtdiode 6A ausgesandte Licht wird in Form eines Lichtsignals zur Meldeeinheit 8 übertragen. Wenn jedoch der Thyristor 1 kurzgeschlossen, z.B. durchlegiert ist, kann sich an der Anoden-Kathoden-Strecke des Thyristors 1 keine Spannung aufbauen und damit fliesst auch kein Strom durch die Leuchtdiode 6A, so dass zur Meldeeinheit 8 kein Lichtsignal übertragen wird. Damit kann also festgestellt werden, ob der Thyristor 1 einen Fehler aufweist oder nicht.

Die aus der Diode 7 und dem Widerstand 5C bestehende Reihenschaltung stellt eine Überspannungs-Schutzschaltung für den Thyristor 1 dar. Die Breakover-Diode 7 weist eine in Figur 2 dargestellte Strom-Spannungs-Kennlinie auf. Diese Kennlinie kann auch durch die in Figur 3a dargestellte Kombination von Thyristor 9 und Z-Diode 10 realisiert werden. Wie in Figur 3B dargestellt kann eine solche Charakteristik durch Reihenschaltung einer Breakover-Diode 12 mit einer Diode 11 realisiert werden, wobei beide Dioden zusammen die in Figur 4 dargestellte Kennlinie aufweisen.

Die Serienschaltung von Diode 7 und Strombegrenzungswiderstand 5C mit der Durchbruchcharakteristik nach Figur 2 ist der Anoden-Kathoden-Strecke des Thyristors 1 parallel geschaltet. Sobald die an der Anoden-Kathoden-Strecke des Thyristors 1 anstehende Spannung die Durchbruchspannung der Breakover-Diode 7 erreicht und damit einen Durchbruch verursacht, wird dem Gate des Thyristors 1 ein Zündimpuls zugeführt. Damit zündet der Thyristor 1, so dass dieser gegen einen Durchbruch aufgrund von Überspannung geschützt werden kann. Um das Ansprechen der Überspannungs-Schutzschaltung zu melden, fliesst ein Teil des zum Widerstand 5C fliessenden Stroms über den Widerstand 5B zur Leuchtdiode 6B. Das durch den genannten Vorgang von der Leuchtdiode 6B erzeugte Lichtsignal wird über den Lichtleiter 3B der Meldeschaltung 8 zugeführt, so dass die am Thyristor 1 anstehende Überspannung gemeldet wird.

Wie das dargestellte Ausführungsbeispiel zeigt, erfordert bei herkömmlichen Schaltungen die Überwachung von Thyristoren auf Fehler und auf Ansprechen der Schutzschaltung getrennte Licht- übertragungssysteme. Dadurch wird die Überwachungsschaltung nicht nur kompliziert, sondern erfordert auch eine Anzahl kostspieliger Lichtleiter und Übertrager- sowie Empfängerelemente. Damit wird eine solche Anordnung recht kostspielig.

Aufgabe der Erfindung ist es daher, eine Überwachungsschaltung für Thyristoren der eingangs genannten Art mit geringerem Aufwand zu realisieren.

Diese Aufgabe wird erfindungsgemäss dadurch gelöst, dass die Meldungen für das Ansprechen des Spannungsfühlers und der Schutzschaltung über einen gemeinsamen Lichtleiter zeitlich getrennt erfolgen, dass dem Spannungsfühler ein monostabiler Multivibrator nachgeschaltet ist, der mit der Leuchtdiode verbunden ist, dass die Schutzschaltung direkt mit der Leuchtdiode verbunden ist und dass zwischen Spannungsfühler und monostabilen Multivibrator ein bistabiles Kippglied geschaltet ist, dessen Rücksetz-Eingang mit dem Spannungsfühler und dessen Setzeingang mit einem Empfänger für Ansteuerimpulse des Thyristors verbunden ist.

Damit ist für jede Überwachungsschaltung nur noch eine Leuchtdiode, ein Lichtleiter und ein Lichtempfänger erforderlich. Wenn die Meldungen für das Ansprechen des Spannungsfühlers und der Schutzschaltung zeitlich eindeutig einer Ansteuerperiode des Thyristors zuzuordnen sind, so können beide Meldungen in der Meldeeinheit getrennt identifiziert werden.

Eine Überwachung zweier antiparallel geschalteten Thyristoren mit jeweils einer Schutzschaltung kann mit einer einzigen Überwachungsschaltung durchgeführt werden, wenn in Serie zu jeder Schutzschaltung eine gemeinsame Reihenschaltung zweier Z-Dioden liegt, wobei diese Reihenschaltung über einen Brückengleichrichter mit der Leuchtdiode verbunden ist.

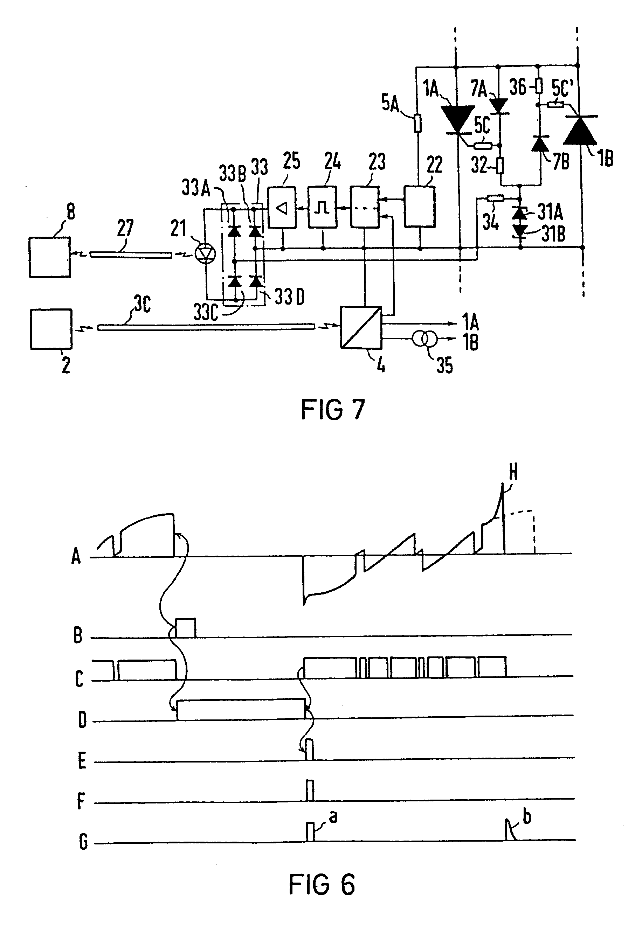

Ausführungsbeispiele der Erfindung werden im folgenden anhand der Figuren 5 bis 8 näher erläutert. Soweit die Ausführungsbeispiele mit der bekannten Schaltung nach Figur 1 übereinstimmen, werden in der folgenden Beschreibung dieselben Bezugszeichen verwendet. Dabei wird auf eine nochmalige Beschreibung verzichtet.

Figur 5 zeigt ein Ausführungsbeispiel der Erfindung für einen einzelnen Thyristor. Diese Figur zeigt eine Leuchtdiode 21. Die am Thyristor 1 anstehende Spannung wird über einen Widerstand 22A durch einen Spannungsfühler 22 erfasst. Ein Flip-Flop 23 wird durch einen Zündimpuls am Ausgang des fotoelektrischen Wandlers gesetzt und durch ein Ausgangssignal des Spannungsfühlers 22 zurückgesetzt. Dem Flip-Flop 23 ist ein monostabiler Multivibrator 24 (im folgenden kurz als Multivibrator bezeichnet) nachgeschaltet, der durch den Rücksetz-Zeitpunkt des Flip-Flops 23 getriggert wird. Dem Multivibrator 24 ist ein Impulsverstärker 25 nachgeschaltet, an dessen Ausgang die Leuchtdiode 21 angeschlossen ist. Ferner enthält die Schaltung die Reihenschaltung einer Breakover-Diode 7 und eines Widerstands 5C als Überspannungs-Schutzschaltung für den Thyristor. Ein Teil des Stroms, der durch diese Überspannungs-Schutzschaltung fliesst, wird über den Widerstand 26 und die Leuchtdiode 21 abgeleitet. Das Ausgangssignal der Leuchtdiode 21 wird über einen Lichtleiter 27 zur Überwachungsschaltung 8 übertragen.

Die Funktion der Schaltung nach Figur 5 wird im folgenden anhand von Figur 6 beschrieben. Figur 6 zeigt den Spannungsverlauf an allen Bauelementen, wenn die Schaltung nach Figur 5 in einem reinen Brückengleichrichter angewandt wird, wobei eine Phasenverschiebung von 90° vorliegen soll. Wenn die Ansteuereinheit 2 ein Lichtsignal als Zündbefehl für den Thyristor 1 über den Lichtleiter 3C an den fotoelektrischen Wandler 4 überträgt, wandelt dieser das Lichtsignal in einen Zündimpuls (B in Figur 6) um. Der Zündimpuls B wird dem Gate des Thyristors 1 zugeführt. Die am Thyristor 1 anstehende Spannung ist in Figur 6 mit A bezeichnet. Gleichzeitig wird das Flip-Flop 23 in die Setzposition gebracht. Der Zustand der Flip-Flops 23 ist in Fig. 6 mit D gekennzeichnet. Sobald der Thyristor 1 wieder ausschaltet und Spannung an der Anoden-Kathoden-Strecke ansteht, erfasst der Spannungsfühler 22 diese Spannung und setzt das Flip-Flop 23 zurück. Damit wird der Multivibrator 24, dessen Zustand in Figur 6 mit E gekennzeichnet ist, getriggert und liefert über den Impulsverstärker 25 einen Stromimpuls für die Leuchtdiode 21.

Das Ausgangssignal des Impulsverstärkers 25 ist in Figur 6 mit F und der Zustand der Leuchtdiode 21 mit G bezeichnet. Das von der Leuchtdiode 21 ausgesandte Licht wird der Meldeschaltung 8 zugeführt.

Sobald die Spannung am Thyristor 1 wieder auf Null zurück geht, wird auch das Ausgangssignal C des Spannungsfühlers wieder Null. Da jedoch der fotoelektrische Wandler 4 keinen Zündimpuls abgibt, bleibt das Flip-Flop 23 zurückgesetzt. Daher kann der Spannungsfühler 22 den Multivibrator 24 nicht triggern. Der Stromimpuls a im Impulsdiagramm G nach Figur 6 tritt daher nur bei ausgeschaltetem Thyristor auf. Dieser Stromimpuls a zeigt also an, dass an der Anoden-Kathoden-Strecke des Thyristors 1 eine Spannung auftritt und dass der Thyristor 1 normal arbeitet.

Wenn das Signal a bei ausgeschaltetem Thyristor nicht auftritt, so bedeutet dies, dass der Thyristor 1 keine Spannung aufnimmt, weil er aufgrund eines Durchbruchs einen Kurzschluss aufweist. Der Durchbruch des Thyristors 1 kann also auf diese Weise signalisiert werden.

In Figur 6, Diagramm A ist mit H ein Spannungsanstieg bezeichnet, bei dem der Überspannungs-Schutz anspricht. Wenn die Breakover-Diode 7 nach Figur 5 durchbricht, wird über die Breakover-Diode 7 und den Widerstand 5C dem Thyristor 1 ein Zündimpuls zugeführt, der diesen zündet. Zusätzlich fliesst über die Breakover-Diode 7 und den Widerstand 26 ein in Figur 6, Impulsdiagramm G mit b bezeichneter Stromimpuls zur Leuchtdiode 21. Die Leuchtdiode 21 sendet damit Licht aus, so dass über den Lichtleiter 27 ein Lichtsignal zur Meldeschaltung 8 übertragen wird. Aus dem Lichtsignal kann daher geschlossen werden, ob der Überspannungs-Schutz angesprochen hat.

Die als Stromimpulse a bzw. b von der Leuchtdiode 21 ausgesandten Lichtsignale werden also über einen Lichtleiter 27 zur Meldeeinheit 8 übertragen. Diese beiden Lichtsignale sind zeitlich voneinander getrennt, so dass sie klar voneinander unterschieden werden können.

Figur 7 zeigt ein Ausführungsbeispiel der vorliegenden Erfindung mit einer Überwachungsschaltung zur Überwachung zweier antiparallel geschalteter Thyristoren. In Figur 7 sind die mit Figur 1 und 5 übereinstimmenden Bauteile mit denselben Bezugszeichen versehen, wobei auf eine nochmalige Beschreibung dieser Bauteile verzichtet wird.

Bei der Schaltung nach Figur 7 sind Thyristoren 1A und 1B antiparallel geschaltet. Dabei ist der Thyristor 1A mit einer aus einer Breakover-Diode 7A und einem Widerstand 5C bestehenden Schutzschaltung und der Thyristor 1B mit einer aus einer Breakover-Diode 7B, einem Widerstand 5C' und Zenerdioden 31A, 31B bestehenden Schutzschaltung versehen. Zwischen die Breakover-Diode 7A und die Zenerdiode 31A ist ein Widerstand 32 eingefügt. Aus Dioden 33A bis 33D wird ein Brückengleichrichter 33 gebildet, dessen Wechselspannungseingänge über einen Widerstand 34 mit der Serienschaltung der Z-Dioden 31A und 31B verbunden sind. Die Leuchtdiode 21 ist mit dem Gleichspannungsausgang der Gleichrichterbrücke verbunden. Der Ausgang des fotoelektrischen Wandlers 4 ist mit dem Setzeingang des Flip-Flops 23, direkt mit dem Gate des Thyristors 1A und schliesslich über einen Impulstransformator 35 mit dem Gate des Thyristors 1B verbunden. Das Gate des Thyristors 1B ist über die Reihenschaltung des Widerstands 5C' und eines Widerstands 36 mit seiner Kathode verbunden.

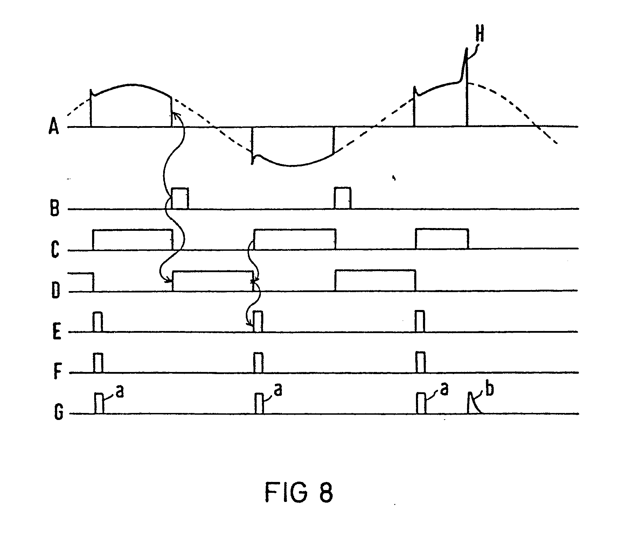

Mit einer derartigen Überwachungsschaltung kann man ebenso wie bei der nach den Figuren 5 und 6 dargestellten Schaltung Fehler aufgrund von Kurzschluss und Überspannung an den Thyristoren 1A und 1B erfassen. Die Funktion der Schaltung nach Figur 7 wird im folgenden anhand der Impulsdiagramme nach Figur 8 dargestellt. Ein von einem fotoelektrischen Wandler 4 gelieferter Zündimpuls wird einem Thyristor 1A zugeführt, wodurch dieser gezündet wird. Wenn dann die Spannung A am Thyristor 1A zusammenbricht, wird das Flip-Flop 23 (in Figur 8 mit D dargestellt) gesetzt. Wenn anschliessend der Thyristor 1A wieder ausgeschaltet wird, wird das Flip-Flop 23 zurückgesetzt. Über den Multivibrator 24 und den Impulsverstärker 25 wird dann ein Stromfluss über die Leuchtdiode 21 erzeugt, so dass diese leuchtet. Wenn die Thyristoren 1A und 1B ausgeschaltet werden, fliesst daher durch die Leuchtdiode 21 ein in Figur 8 (G) dargestellter Stromimpuls a.

Im folgenden wird die Funktion der Überspannungs-Schutzschaltung erläutert. Wenn die Breakover-Diode 7a durchbricht während der Thyristor 1A eine Spannung in Durchlassrichtung aufweist, wird dem Thyristor 1A über die Breakover-Diode 7A und den Widerstand 5C ein Zündimpuls zugeführt. Gleichzeitig fliesst ein Strom von der Breakover-Diode 7A und den Widerstand 32 durch die Z-Dioden 31A und 31B. Wenn dagegen bei einer Spannung in Durchlassrichtung des Thyristors 1B die Breakover-Diode 7B durchbricht, wird dem Thyristor 1B über die Zenerdioden 31A und 31B, die Breakover-Diode 7B und den Widerstand 5C' ein Zündimpuls zugeführt. In jedem Fall fliesst ein Strom durch die Zenerdioden 31A und 31B. An den Enden der Serienschaltung der Zenerdioden 31A und 31B steht daher eine auf einen vorgegebenen Wert begrenzte Zenerspannung an, deren Polarität wechselt.

Wenn daher eine der Überspannungs-Schutzeinrichtungen anspricht, erzeugt der Spannungsabfall an den Zenerdioden 31A und 31B einen vom Widerstand 34 begrenzten Strom. Dieser fliesst über die Gleichrichterbrücke 33 zur Leuchtdiode 21, wobei die Leuchtdiode 21 Licht aussendet. Das Lichtsignal der Leuchtdiode 21 wird über einen Lichtleiter 27 zur Meldeschaltung 8 übertragen. Sobald daher die Überspannungs-Schutzeinrichtung wie in Figur 8 (A) dargestellt, anspricht, entsteht der in Figur 8 (G) dargestellte Stromimpuls b. Wie bei der Überwachungsschaltung nach Figur 5 ermöglicht daher ein einziger Lichtleiter 27 eine Überwachung der Thyristoren 1A und 1B auf Kurzschluss sowie auf Ansprechen der Überspannungs-Schutzeinrichtungen für die Thyristoren 1A und 1B.

Wenn der in Figur 8 dargestellte Spannungsverlauf A der Thyristorspannung nicht auf Null geht und die Ausgangsspannung des Spannungsfühlers während einer Sperrphase der Thyristoren 1A und 1B sich nicht umkehrt, kann das Flip-Flop 23 weggelassen werden. Das heisst also, dass, auch wenn der Multivibrator 24 direkt vom Spannungsfühler 22 getriggert wird, zum Ausschaltzeitpunkt der Thyristoren 1A und 1B ein Stromimpuls a durch die Leuchtdiode 21 fliesst. Die Leuchtdiode 21 kann daher unter den genannten Voraussetzungen auch ohne Flip-Flop 23 betrieben werden.

Zusammenfassend ist also festzustellen, dass bei der vorliegenden Erfindung beim Ausschalten des Thyristors die am Thyristor anstehende Spannung erfasst wird. Es ist eine Schaltung vorgesehen, die nur zu diesem Zeitpunkt ein Impulssignal abgibt, so dass derselbe Lichtleiter zur Überwachung des Thyristors auf Kurzschluss und auf Ansprechen einer Überspannungs-Schutzschaltung für den Thyristor verwendet werden kann. Daher kann die Zahl der Lichtleiter zur Meldeeinheit auf die Hälfte reduziert, die Meldeeinheit vereinfacht und die Anordnung verbilligt werden.

Auch wenn sich die Beschreibung auf einen Hochspannungs-Thyristorumrichter bezieht, können Lichtleiter nach der vorliegenden Erfindung auch zur Überwachung von Niederspannungs-Thyristorumrichtern eingesetzt werden, die beispielsweise einer induktiven Belastung unterliegen.

## Patentansprüche

1. Überwachungsschaltung für einen Thyristor (1) zur Überwachung auf Kurzschluss und Überspannung mit einem Spannungsfühler (22) für die am Thyristor anstehende Spannung, mit einer Schutzschaltung (7) zur Zündung des Thyristors bei anstehender Überspannung sowie mit einer Leuchtdiodenanordnung, die bei Ansprechen des Spannungsfühlers bei abgeschaltetem Thyristor und bei Ansprechen der Schutzschaltung je eine Meldung in Form eines Lichtsignals aussendet, wobei die Leuchtdiodenanordnung über eine Lichtleiteranordnung mit einer Meldeeinheit für Kurzschluss und Überspannung verbunden ist, dadurch gekennzeichnet, dass die Meldungen für das Ansprechen des Spannungsfühlers (22) und der Schutzschaltung (7) über eine gemeinsame Leuchtdiode (21) und einen gemeinsamen Lichtleiter (27) zeitlich getrennt erfolgen, dass dem Spannungsfühler (22) ein monostabiler Multivibrator (24) nachgeschaltet ist, der mit der Leuchtdiode (21) verbunden ist, dass die Schutzschaltung (7) direkt mit der Leuchtdiode (21) verbunden ist und dass zwischen Spannungsfühler (22) und monostabilen Multivibrator (24) ein bistabiles Kippglied (23) geschaltet ist, dessen Rücksetz-Eingang mit dem Spannungsfühler (22) und dessen Setzeingang mit einem Empfänger (4) für Ansteuerimpulse des Thyristors (1) verbunden ist.

2. Überwachungsschaltung nach Anspruch 1 für zwei antiparallel geschaltete Thyristoren mit jeweils einer Schutzschaltung, dadurch gekennzeichnet, dass in Serie zu jeder Schutzschaltung (7A, 7B) eine gemeinsame Reihenschaltung zweier Z-Dioden (31A, 31B) liegt und dass diese Reihenschaltung über einen Brückengleichrichter (33) mit der Leuchtdiode (21) verbunden ist.

## Claims

1. A control circuit for a thyristor (1) to monitor shortcircuits and excess voltage, comprising a voltage sensor (22) for the voltage occurring across the thyristor, comprising a protective circuit (7) which serves to ignite the thyristor in the presence of excess voltage, and comprising a luminescence diode arrangement which acts in the event of a voltage sensor response when the thyristor is disconnected and in the event of a protective circuit response, and in each case transmits a message in the form of a light signal, where the luminescence diode arrangement is connected via a light conductor arrangement to a message unit for short-circuits and excess voltage, characterised in that the messages for response of the voltage sensor (22) and the protective circuit (7) are given at separate times via a common luminescence diode (21) and a common light conductor (27), that the voltage sensor (22) output is connected to a monostable multivibrator (24) connected to the luminescence diode (21), that the protective circuit (7) is directly connected to the luminescence diode (21) and that between the voltage sensor (22) and the monostable multivibrator (24) there is connected a bistable circuit (23) whose reset-input is connected to the voltage sensor (22) and whose set input is connected to a receiver (4) for thyristor (1) drive pulses.

2. A control circuit as claimed in Claim 1 for two thyristors connected in anti-parallel, each comprising a protective circuit, characterised in that a common series circuit consisting of two Zener diodes (31A, 31B) is connected in series with each protective circuit (7A, 7B) and that this series circuit is connected to the luminescence diode (21) via a bridge rectifier (33).

## Revendications

1. Montage de surveillance pour un thyristor (1), destiné à la surveillance contre un court-circuit et des surtensions, comprenant un détecteur de tension (22) pour détecter la tension appliquée au thyristor, un circuit de protection (7) pour amorcer le thyristor en cas d'application d'une surtension, ainsi qu'un dispositif à diode électroluminescente qui, en cas de réaction du détecteur de tension, alors que le thyristor est non conducteur, et en cas de réaction du circuit de protection, émet une signalisation sous forme d'un signal lumineux, le dispositif à diode électroluminescente étant relié par un dispositif à guides de lumière à une unité de signalisation de court-circuit et de surtension, caractérisé en ce que les signalisations pour les réactions du détecteur de tension (22) et du circuit de protection (7) s'effectuent, séparément dans le temps, par une diode électroluminescente (21) commune et par un guide de lumière (27) commun, que le détecteur de tension (22) est suivi d'un multivibrateur monostable (24) relié à la diode électroluminescente (21), que le circuit de protection (7) est connecté directement à la diode électroluminescente (21) et qu'un élément bascule bistable (23) est branché entre le détecteur de tension (22) et le multivibrateur monostable (24) et est connecté par son entrée de remise à 0 au détecteur de tension (22) et par son entrée de mise à 1 à un récepteur (4) d'impulsions de commande du thyristor (1).

2. Montage de surveillance selon la revendication 1 pour deux thyristors montés tête-bêche, à chacun desquels est coordonné un circuit de protection, caractérisé en ce qu'un montage en série commun de deux diodes Zener (31A, 31B) est branché en série avec chaque circuit protection (7A, 7B) et que ce montage en série de deux diodes est relié à travers un redresseur en pont (33) à la diode électroluminescente (21).

FIG 1

FIG 2

FIG 3

FIG 4

FIG 5

FIG 7

FIG 6

FIG 8